# FASCICULE DE BREVET EUROPEEN

(11) **EP 0 533 557 B1**
(45) Date de publication et mention de la délivrance du brevet: **18.03.1998**
(21) Numéro de dépôt: 92402529.9
(22) Date de dépôt: 16.09.1992
(51) Int. Cl.: H05K 7/18, H02B 1/01, F16B 12/50

(54) **Ossature d'armoire, notamment pour appareillages électriques, et ossature et armoire correspondantes**
Schrankrahmen, insbesondere für elektrische Aggregate, entsprechender Schrank
Cabinet frame, particularly for electrical apparatus and cabinet using it

(30) Priorité: 18.09.1991 FR 9111485
(43) Date de publication de la demande: 24.03.1993
(73) Titulaire: LEGRAND, F-87045 Limoges Cédex (FR)
(72) Inventeur: Baudouin, Pascal 58 Avenue Georges Bizet, F-76380 Canteleu (FR); Bouteiller, Pascal, F-76160 Darnetal (FR); Desforges, Rémi, F-76850 Bosc Le Hard (FR)
(74) Mandataire: CABINET BONNET-THIRION

(56) Documents cités:
- DE-U- 7 639 745
- DE-U- 8 802 893
- LU-A- 56 323

## Description

La présente invention concerne une ossature pour les armoires du type de celles mises en oeuvre par exemple pour le logement d'appareillages électriques.

Elle vise plus particulièrement celles de ces armoires qui sont dites assemblables, c'est-à-dire celles dont le montage final peut si désiré être effectué in situ.

Ces armoires assemblables comportent, globalement, d'une part, une ossature, qui est formée d'un certain nombre d'éléments d'ossature, en l'espèce des montants ou des traverses, en pratique des profilés, convenablement assemblés en trièdre par des pièces d'assemblage intervenant usuellement dans trois dimensions, et, d'autre part, dûment rapportées sur cette ossature, un certain nombre de parois dont une au moins constitue une porte.

L'un des problèmes à résoudre dans la réalisation de telles armoires assemblables tient notamment à la diversité des volumes à constituer.

Partant, par exemple, pour des raisons de standardisation de fabrication, d'un certain module de base, il peut être nécessaire, suivant le nombre et/ou la nature des appareillages électriques à loger, de constituer des armoires dont le volume interne correspond à un ou plusieurs de tels modules.

En pratique, les ventes les plus fréquentes concernent statistiquement des armoires dont le volume interne correspond à deux ou trois modules.

Pour la réalisation de telles armoires, une première solution peut consister à accoler les uns aux autres le nombre de modules nécessaire.

Mais le montage correspondant, s'il se fait sur le site, est alors à la charge de l'usager.

En outre, des précautions particulières, d'étanchéité, sont à prévoir à la jonction entre deux modules.

En pratique, un joint d'étanchéité doit être établi tout autour du périmètre de jonction correspondant, entre les éléments d'ossature alors accolés le long de ce périmètre.

Enfin, ces éléments d'ossature, qui, de surcroît, interviennent ainsi systématiquement en double, de manière quelque peu redondante, font alors partie intégrante de l'ossature d'ensemble à la constitution de laquelle ils participent, et ils constituent donc par eux-mêmes une gêne permanente vis-à-vis d'un accès global au volume interne de l'armoire concernée.

Une deuxième solution pour la réalisation d'armoires dont le volume interne correspond à deux ou plusieurs modules consiste à établir dès l'origine en conséquence, de manière monobloc, l'ossature nécessaire, en prolongeant en rapport les éléments d'ossature intervenant suivant la dimension, longueur ou hauteur, le long de laquelle doit s'étendre une telle armoire.

Mais, se faisant au détriment de la standardisation, une telle réalisation monobloc est en général relativement coûteuse.

En outre, si, indépendamment du toit, qui est toujours d'un seul tenant, les parois à rapporter sur l'ossature restent standard, il est nécessaire, pour leur implantation, d'entailler à leur jonction les éléments d'ossature prolongés que comporte une telle ossature, pour libérer la place nécessaire aux retours en équerre, ou plis, que présentent usuellement à leur périphérie de telles parois pour leur raidissement.

Outre le travail nécessaire à l'encochage correspondant, des dispositions particulières, délicates et dispendieuses, sont alors à mettre en oeuvre au droit des entailles de ces éléments d'ossature, pour rétablir la continuité d'étanchéité de l'ensemble.

Dans le brevet luxembourgeois No 56323, il est décrit une pièce d'assemblage, qui, si elle a globalement une configuration en T, résulte de la superposition de deux éléments distincts, au prix d'une complication du montage.

En outre, les éléments d'ossature à relier par cette pièce d'assemblage sont tous des éléments tubulaires à emboîter sur celle-ci, et il n'est donc pas possible d'en retirer un sans intervenir sur l'ensemble.

La présente invention a d'une manière générale pour objet une disposition permettant d'éviter les divers inconvénients mentionnés ci-dessus et conduisant en outre à d'autres avantages.

De manière plus précise, elle a tout d'abord pour objet une ossature pour armoire, notamment pour appareillages électriques, formée d'une pluralité d'éléments d'ossature reliés par des pièces d'assemblage et caractérisée en ce que, l'une au moins des pièces d'assemblage présentant, sous une configuration en forme générale de T, d'une part, dans l'alignement l'un de l'autre, deux bras qui reçoivent, chacun respectivement, par simple emboîtement axial, deux éléments d'ossature de même section transversale, tels que traverses ou montants, et, d'autre part, perpendiculairement auxdits bras, au droit d'une partie médiane de jonction qui les relie l'un à l'autre, un jambage avec lequel coopère un troisième élément d'ossature, tel que montant ou traverse, ledit troisième élément d'ossature est de section transversale différente de celle des éléments d'ossature précédents, et il est simplement adossé audit jambage, avec, entre lui et ce jambage, des moyens de fixation débrayables ; elle a encore pour objet toute armoire comportant une telle ossature.

En bref, au lieu de correspondre à la jonction, en trièdre, de trois éléments d'ossature, comme cela est le cas aux angles d'une ossature, la pièce d'assemblage suivant l'invention correspond pour l'essentiel à la jonction en T, dans un même plan, de ces trois éléments d'ossature, et elle est donc à même d'intervenir suivant une dimension quelconque d'une telle ossature, soit qu'il s'agisse, pour la constitution de celle-ci, de disposer côte à côte en longueur deux modules, soit qu'il s'agisse de superposer en hauteur l'un à l'autre ces modules ou d'en diviser un en deux.

Ainsi, au lieu de se développer dans trois dimensions, la pièce d'assemblage suivant l'invention ne s'étend pour l'essentiel que dans un plan, tout en permettant, si désiré, ou si nécessaire, l'intervention d'un quatrième élément d'ossature perpendiculairement à ce plan.

En bref, la pièce d'assemblage suivant l'invention favorise de manière très souple la réalisation à volonté d'armoires dont le volume interne correspond dès l'origine à un ou plusieurs modules.

A prestations globales égales, les armoires ainsi réalisées s'avèrent moins onéreuses que celles dont l'ossature est monobloc et elles suppriment avantageusement tout montage spécifique chez l'utilisateur.

En outre, il est avantageusement possible, grâce à la pièce d'assemblage suivant l'invention, de rendre amovible l'élément d'ossature appuyé contre le jambage qu'elle comporte.

Cet élément d'ossature étant en effet simplement adossé à ce jambage, il suffit de prévoir entre lui et celui-ci des moyens de fixation débrayables, en pratique de simples vis.

L'élément d'ossature correspondant étant ainsi amovible, il est avantageusement possible de procéder temporairement à sa dépose chaque fois qu'il est nécessaire d'intervenir dans le volume interne de l'armoire concernée, en facilitant ainsi les opérations correspondantes.

Enfin, la pièce d'assemblage suivant l'invention présente préférentiellement dans sa partie médiane une échancrure, permettant avantageusement la mise en oeuvre de parois standard sans avoir à procéder à une quelconque entaille sur le site.

Conjointement, sa partie médiane de jonction présente, préférentiellement, en saillie, à la racine, chacun respectivement, de ses bras, perpendiculairement au plan que ceux-ci forment avec son jambage, deux plots propres à assurer une continuité de jonction entre les divers éléments d'ossature concernés, en permettant ainsi par elle-même, sans mise en oeuvre de disposition spécifique à cet effet, toute la continuité d'étanchéité nécessaire entre ces éléments d'ossature et les parois correspondantes.

Les caractéristiques et avantages de l'invention ressortiront d'ailleurs de la description qui va suivre, à titre d'exemple, en référence aux dessins schématiques annexés sur lesquels :
la figure 1 est une vue en perspective d'une armoire susceptible de mettre en oeuvre plusieurs pièces d'assemblage suivant l'invention ;
la figure 2 est une vue en perspective éclatée de l'ossature de cette armoire ;
la figure 3 est, à échelle supérieure, une vue en perspective illustrant la mise en oeuvre d'une pièce d'assemblage suivant l'invention dans la constitution de cette ossature, lorsqu'elle intervient à la partie haute de celle-ci ;
la figure 4 est une vue en perspective de cette seule pièce d'assemblage, représentée isolément, vue de l'avant et légèrement par dessus, suivant une orientation inverse de celle qui est la sienne sur la figure 3 ;
la figure 5 en est une autre vue en perspective, vue de l'arrière et légèrement par dessous, suivant la même orientation que celle qui est la sienne sur la figure 4 ;
la figure 6 en est, à échelle supérieure, une vue en plan, suivant la flèche VI de la figure 4 ;
la figure 7 est une vue en perspective éclatée illustrant la mise en oeuvre de cette pièce d'assemblage lorsqu'elle intervient à la partie basse de l'ossature correspondante ;
la figure 8 est une vue en perspective partielle d'un élément d'ossature susceptible d'être substitué à l'un de ceux représentés à la figure 7 ;
la figure 9 est une vue en perspective d'une barrette susceptible d'être mise en oeuvre en l'absence d'un tel élément d'ossature ;
les figures 10 et 11 sont des vues en perspective qui, analogues à celle de la figure 1, se rapportent chacune respectivement à des configurations différentes pour l'armoire concernée.

Tel qu'illustré sur ces figures, il s'agit, globalement, de la réalisation d'une armoire 10 comportant, alignés côte à côte, en longueur, une pluralité de modules.

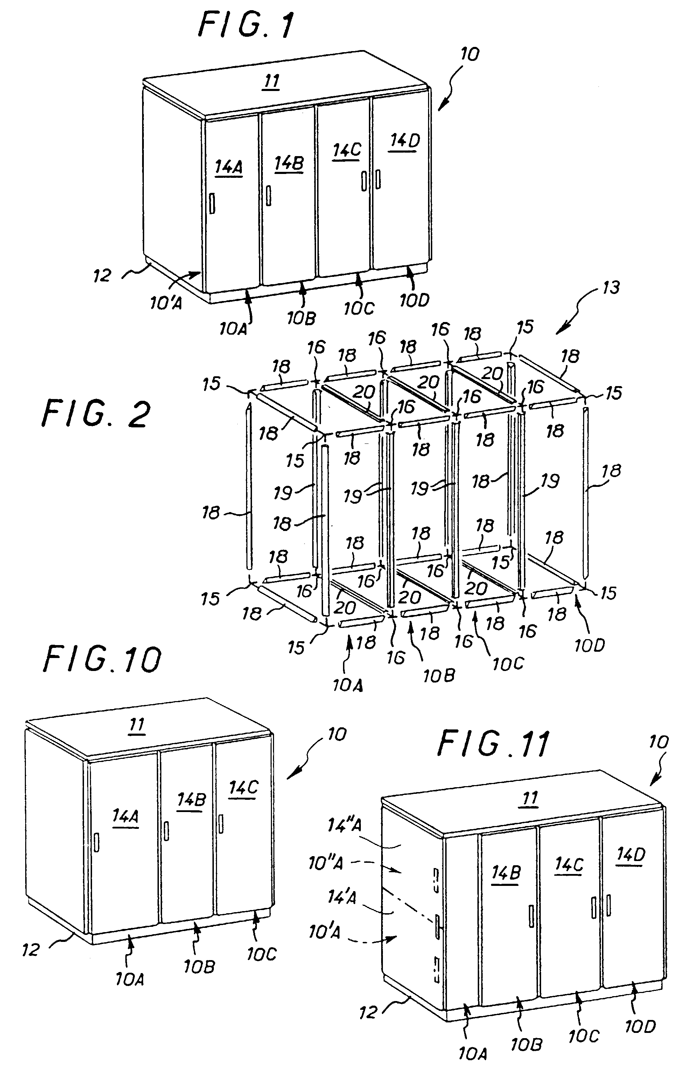

Dans la forme de mise en oeuvre plus particulièrement représentée sur la figure 1, il y a ainsi, à titre d'exemple, sous un même toit 11 et sur un même socle 12, quatre modules 10A, 10B, 10C, 10D, tous de même largeur, de même hauteur, et de même profondeur.

De manière connue en soi, cette armoire 10 est constituée d'une ossature 13 sur laquelle sont rapportées des parois, dont certaines, au moins, constituent des portes, et c'est le cas pour l'ensemble de celles, 14A, 14B, 14C et 14D, qui, dans la forme de réalisation représentée, sont présentes en façade.

De manière également connue en soi, l'ossature 13, dont la configuration propre est une configuration en modules 10A, 10B, 10C, 10D correspondant à celle de l'armoire 10, est formée d'une pluralité d'éléments d'ossature reliés par des pièces d'assemblage.

Les pièces d'assemblage 15 présentes aux angles de l'ensemble ne sont pas en cause ici, et elles ne seront donc pas décrites.

Seules sont en cause ici les pièces d'assemblage 16 intermédiaires.

Chacune d'elles relie au moins trois éléments d'ossature.

Il s'agit, d'une part, de deux éléments d'ossature 18, qui, de même nature, s'étendent suivant les arêtes de l'ensemble, qu'il s'agisse de montants horizontaux ou de traverses verticales, et, d'autre part, d'un élément d'ossature 19, qui, spécifique à la présente invention, est à la jonction de deux modules, et il s'agit en pratique, dans la forme de réalisation représentée, de montants verticaux.

Dans la forme de réalisation représentée, les pièces d'assemblage 16 sont également concernées par un quatrième élément d'ossature 20.

Il s'agit alors en pratique d'une traverse horizontale perpendiculaire à l'alignement des modules 10A, 10B, 10C, 10D.

Les éléments d'ossature 18 sont des profilés et ont tous une même section transversale.

Cette section transversale, qui peut être très diverses, n'est pas en cause ici.

Elle ne sera donc pas décrite dans tous ses détails ici.

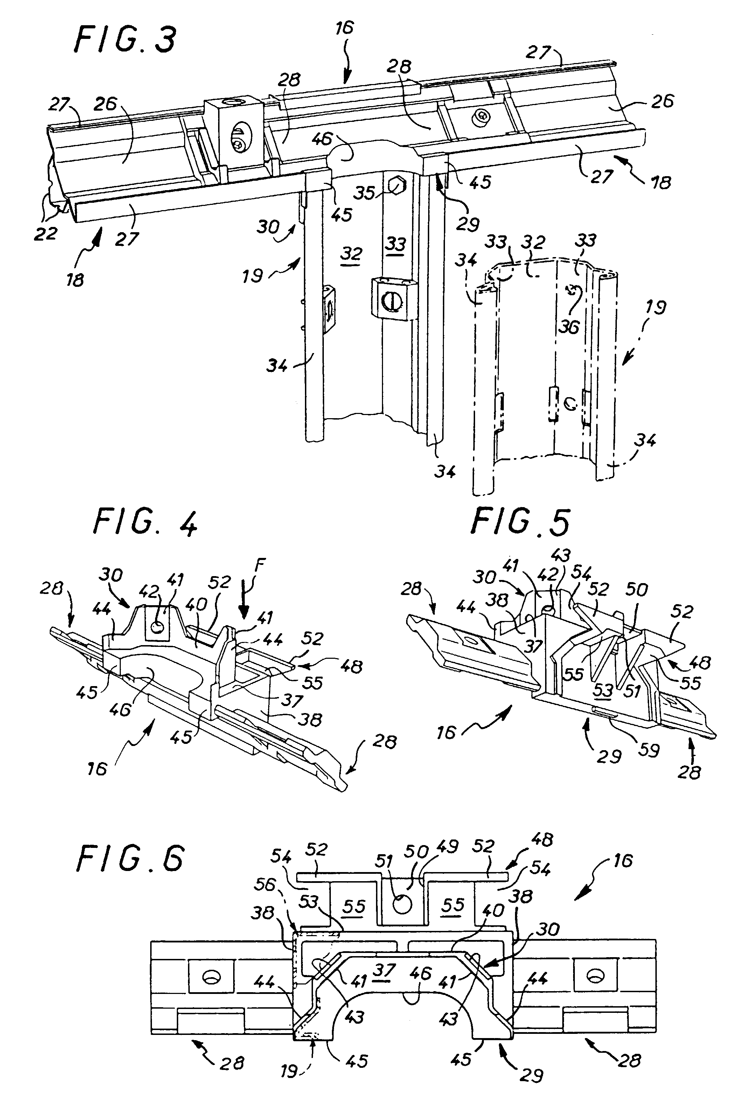

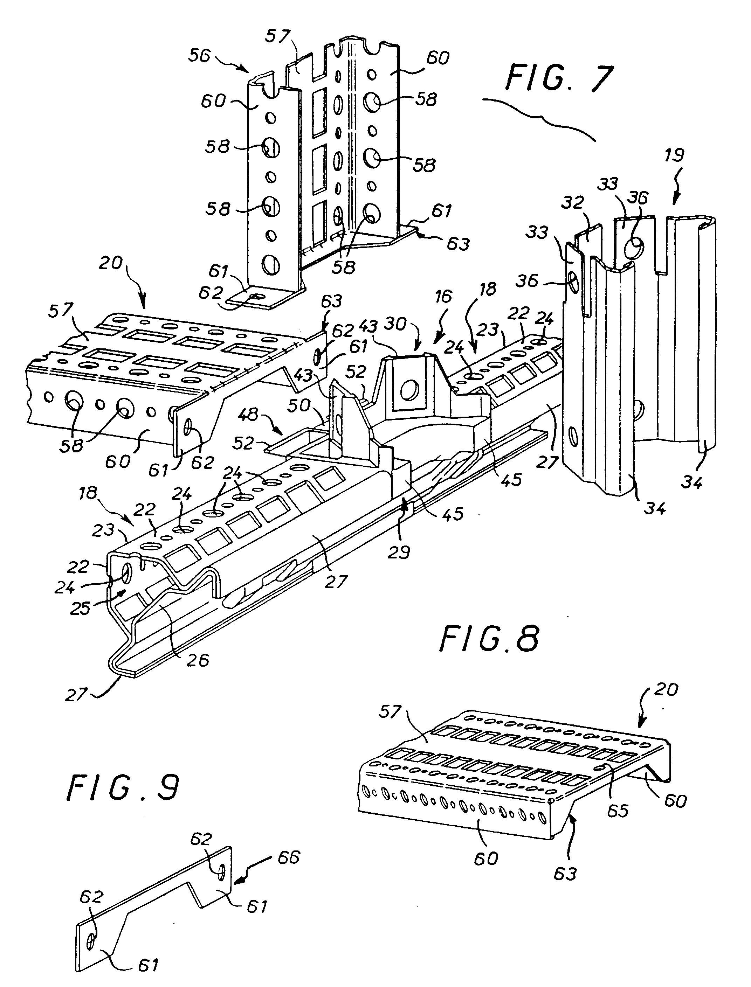

Il suffira d'indiquer que, dans la forme de réalisation représentée, et ainsi qu'il est mieux visible sur les figures 3 et 7, ces éléments d'ossature 18 comportent en équerre deux ailes 22, dont l'arête commune 23 est tournée vers l'intérieur de l'ossature 13 et qui présentent de place en place, des trous 24.

Les ailes 22 définissent entre elles un canal tubulaire 25 fermé vers l'extérieur par une paroi 26 inclinée à 45° sur l'une et l'autre d'entre elles, et, le long de leur bord, elles présentent chacune, parallèlement à l'autre, un retour en équerre 27.

Suivant l'invention, chaque pièce d'assemblage 16 présente, sous une configuration générale en forme de T, d'une part, dans l'alignement l'un de l'autre, deux bras 28 qui reçoivent, chacun respectivement, par simple emboîtement axial, deux éléments d'ossature 18 de même section transversale, tels que traverses ou montants, et, d'autre part, perpendiculairement à ces bras 28, au droit d'une partie médiane de jonction 29 qui les relie l'un à l'autre, un jambage 30 avec lequel coopère un troisième élément d'ossature, en l'espèce un élément d'ossature 19, tel que montant ou traverse, ce troisième élément d'ossature 19 est de section transversale différente de celle des éléments d'ossature 18 précédents, et il est simplement adossé au jambage 30, en appui contre celui-ci, avec, entre lui et ce jambage 30, tel qu'explicité ultérieurement, des moyens de fixation débrayables.

L'élément d'ossature 19 adossé au jambage 30 de la pièce d'assemblage 16, est lui aussi un profilé.

Par sa face tournée vers l'extérieur, il correspond fonctionnellement à deux éléments d'ossature 18 de même nature.

Il comporte donc, notamment, dans la forme de réalisation représentée, disposées chacune respectivement de part et d'autre d'une partie médiane 32 plane, deux parties latérales 33 inclinées à 45°, à la manière de la paroi de fermeture 26 des éléments d'ossature 18.

Il comporte également, à la manière des retours 27 de ces éléments d'ossature 18, deux retours 34, qui, situés dans un même plan, s'étendent parallèlement à sa partie médiane 32.

Dans la forme de réalisation représentée, les moyens de fixation débrayables prévus entre un tel élément d'ossature 19 et le jambage 30 d'une pièce d'assemblage 16 sont de simples vis 35 qui interviennent à la faveur des parties latérales 33, dûment munies de trous 36 à cet effet, de cet élément d'ossature 19.

Dans la forme de réalisation représentée, la partie médiane de jonction 29 d'une pièce d'assemblage 16 présente une surface principale 37, qui est globalement plane, à compter de laquelle s'étend le jambage 30, et deux surfaces latérales 38, qui, parallèles l'une à l'autre, et elles aussi globalement planes, sont perpendiculaires à la surface principale 37 précédente, et à compter desquelles s'étendent chacun respectivement les deux bras 28.

Dans la forme de réalisation représentée, et suivant des dispositions qui, ne relevant pas de la présente invention, ne seront pas décrites en détail ici, ces bras 28 se présentent sous la forme générale de plaquettes, qui sont inclinées à 45° par rapport à la surface principale 37, et sur lesquelles peuvent être engagés, par leur retour 27, les éléments d'ossature 18, à l'extérieur de leur canal tubulaire 25.

Dans la forme de réalisation représentée, le jambage 30 se réduit quant à lui à une collerette de configuration propre à permettre d'y adosser, de l'extérieur, l'élément d'ossature 19 concerné.

Le jambage 30 comporte donc, notamment, disposées chacune respectivement de part et d'autre d'une partie médiane 40 propre à l'appui de la partie médiane 32 d'un tel élément d'ossature 19, deux parties latérales 41, qui, destinées à l'appui des parties latérales 33 d'un tel élément d'ossature 19, sont obliques à 45° par rapport à la partie médiane 32 précédente, et présentent chacune un trou 42 pour le passage de la vis 35 associée, celle-ci étant destinée à coopérer avec un écrou, non représenté, au-delà d'une telle partie latérale 41.

Par exemple, cet écrou est un écrou porté par une agrafe à la manière de ceux commercialisés sous la dénomination "RAPID".

Pour l'implantation d'un tel "RAPID", les parties latérales 41 du jambage 30 présentent chacune un lamage 43 de leur trou 42.

En pratique, le jambage 30 se complète latéralement par des bras 44 destinés à l'appui des bords latéraux de l'élément d'ossature 19.

Préférentiellement, et tel que représenté, la partie médiane de jonction 29 de la pièce d'assemblage 16 présente, en saillie, à la racine, chacun respectivement, de ses bras 28, perpendiculairement au plan que forment ceux-ci avec son jambage 30, deux plots 45 propres à assurer une continuité de jonction entre les éléments d'ossature 18 et 19 à assembler.

Ces plots 45 ont a charge d'abouter, en équerre, les retours 27 ou 34 de ces éléments d'ossature 18, 19, en étant alors à niveau avec ceux-ci.

Grâce à une telle disposition, le joint d'étanchéité dont est usuellement dotée la paroi correspondante de l'armoire 10 trouve avantageusement une continuité d'appui.

Entre les plots 45, la partie médiane de jonction 29 de la pièce d'assemblage 16 présente, dans la forme de réalisation représentée, une large échancrure 46.

Celle-ci permet l'engagement du retour en équerre, ou pli, que présente usuellement à sa périphérie une telle paroi pour son renfort.

Dans la forme de réalisation représentée, la partie médiane de jonction 29 d'une pièce d'assemblage 16 présente, par ailleurs, en saillie, à son dos, perpendiculairement au plan que forment ses bras 28 et son jambage 30, du côté opposé à son échancrure 46, une console 48 propre à l'appui d'un quatrième élément d'ossature, en l'espèce un élément d'ossature 20.

Dans la forme de réalisation représentée, cette console 48 s'étend à compter d'une surface 53 de la partie médiane de jonction 29 qui, à la fois, est perpendiculaire à la surface principale 37 de celle-ci, et, à la fois, est perpendiculaire à ses surfaces latérales 38.

Elle comporte, d'une part, une partie médiane 50, qui, pour la fixation d'un élément d'ossature 20, présente, autour d'un lamage 49 propre à la mise en place d'un écrou "RAPID", un perçage 51 propre au passage d'une vis, et, d'autre part, disposées chacune respectivement de part et d'autre de cette partie médiane 50, sensiblement à niveau avec celle-ci, deux équerres 52.

L'une des ailes de ces équerres 52 s'étend perpendiculairement à la surface 53 correspondante de cette partie médiane de jonction 29 tandis que l'autre s'étend parallèlement à cette surface 53, à distance de celle-ci, en ménageant entre elle et cette surface 53 un évidement 54, tout en lui étant reliée, en retrait, par une entretoise 55 qui, le long de son bord libre, c'est-à-dire du côté opposé à la partie médiane 50, s'efface en oblique.

Enfin, dans la forme de réalisation représentée, la partie médiane de jonction 29 d'une pièce d'assemblage 16 présente, en saillie, sur sa surface opposée à sa surface principale 37, un ergot allongé 59 destiné à coopérer en emboîtement avec un autre constituant, non représenté sur les figures.

Il résulte de ce qui précède que, dans l'ossature 13, chacun des éléments d'ossature 19 adossé au jambage 30 d'une pièce d'assemblage 16 est avantageusement amovible individuellement, indépendamment de cette pièce d'assemblage 16 et des autres éléments d'ossature 18 qu'elle relie.

Si désiré, et tel que schématisé sur la partie de gauche de la figure 6 et tel que représenté à la figure 7, chaque élément d'ossature 19 est doublé par un autre élément d'ossature 56, qui suit le contour de la surface principale 37 de la partie médiane de jonction 29 de la pièce d'assemblage 16, et qui, lui aussi, mais par sa face tournée vers l'intérieur, correspond fonctionnellement à deux éléments d'ossature 18 de même nature.

Cet élément d'ossature 56 comporte donc, à la manière des ailes 22 des éléments d'ossature 18, d'une part, une partie médiane 57 présentant latéralement de place en place des trous 58 suivant une même disposition que les trous 24 de ces ailes 22, et, d'autre part, disposés chacun respectivement le long de cette partie médiane 57, deux retours en équerre 60, présentant eux aussi, de place en place, suivant une même disposition, des trous 58.

A chacune de ses extrémités, cet élément d'ossature 56 présente, latéralement, en saillie, deux pattes 61 par lesquelles il est apte à être assujetti aux éléments d'ossature 18 associés aux bras 28 de la pièce d'assemblage 16 correspondante.

En pratique, ces pattes 61, qui sont chacune percées d'un trou 62, forment les extrémités d'une barrette 63, qui, venue d'un seul tenant de la partie médiane 57, est repliée en équerre contre la tranche des retours en équerre 60.

Dans la forme de réalisation représentée sur la figure 7, l'élément d'ossature 20, qui s'étend perpendiculairement au plan que forment avec son jambage 30 les bras 28 de la pièce d'assemblage 16, a une constitution analogue à celle de l'élément d'ossature 56 précédent.

Il présente donc, lui aussi, latéralement, en saillie, deux pattes 61 par lesquelles il est apte à être assujetti aux éléments d'ossature 18 correspondants.

En variante, figure 8, pour le cas où les trous 24 correspondants de ces éléments d'ossature 18 seraient occupés en raison de la mise en oeuvre d'autres dispositions, l'élément d'ossature 20 présente, à chacune de ses extrémités, suivant l'axe de sa partie médiane 57, un trou 65 propre à en permettre l'assujettissement par une vis à la console 48 de la pièce d'assemblage 16, à la faveur du perçage 51 de la partie médiane 50 de celle-ci.

Comme précédemment, cette vis coopère alors avec un écrou, non représenté, au-delà de la console 48.

Conjointement, aucune patte latérale 61 n'est alors prévue.

Dans tous les cas, le fait que les entretoises 55 des équerres 52 constitutives de la console 48 soient en retrait et s'effacent ensuite en oblique permet avantageusement l'implantation d'un écrou au droit des trous 58 externes d'un tel élément d'ossature 20 si désiré.

Les modalités pratique d'une telle implantation ne relevant pas de la présente invention, elles ne seront pas décrites ici.

Lorsque, enfin, aucun élément d'ossature 20 n'est mis en oeuvre, les éléments d'ossature 18 associés aux bras 28 d'une pièce d'assemblage 16, sont reliés l'un à l'autre par une barrette 66 qui, tel que représenté à la figure 9, forme, à ses extrémités, à la manière de la barrette 63, deux pattes latérales 61 munies chacune d'un trou 62.

Il ressort de ce qui précède que, suivant l'invention, au lieu d'être établis sur la base d'ossatures individuelles, les modules 10A, 10B, 10C, 10D ... que comporte l'armoire 10 sont établis conjointement sur la base d'une même ossature 13 qui, au lieu d'être d'un seul tenant, est elle-même de configuration modulaire.

Dans la variante de mise en oeuvre illustrée par la figure 10, seuls trois modules 10A, 10B, 10C sont prévus, et le module 10A, qui s'étend en continu sur toute sa hauteur, a une largeur supérieure à celle des modules 10B, 10C.

Dans la variante de mise en oeuvre illustrée par la figure 11, quatre modules 10A, 10B, 10C, 10D sont prévus, mais le module 10A s'étend latéralement, au lieu de s'étendre dans l'alignement des autres.

En outre, et tel que schématisé en traits interrompus, il peut si désiré être subdivisé en hauteur en deux sous-modules 10'A, 10"A dûment superposés l'un à l'autre et dotés chacun respectivement d'une porte 14'A, 14"A.

Les pièces d'assemblage 16 correspondantes, non représentées, relient alors précédemment, d'une part, deux profilés 18, qui, de longueur appropriée, forment des montants verticaux, et, d'autre part, un profilé 19, qui, de longueur également appropriée, forme conjointement une traverse.

## Revendications

1. Ossature pour armoire, notamment pour appareillages électriques, formée d'une pluralité d'éléments d'ossature (18, 19, 20) reliés par des pièces d'assemblage (15, 16), caractérisée en ce que, l'une au moins des pièces d'assemblage (16) présentant, sous une configuration générale de T, d'une part, dans l'alignement l'un de l'autre, deux bras (28), qui reçoivent, chacun respectivement, par simple emboîtement axial, deux éléments d'ossature (18) de même section transversale, tels que traverses ou montants, et, d'autre part, perpendiculairement auxdits bras (28), au droit d'une partie médiane de jonction (29) qui les relie l'un à l'autre, un jambage (30) avec lequel coopère un troisième élément d'ossature (19), tel que montant ou traverse, ledit troisième élément d'ossature (19) est de section transversale différente de celle des éléments d'ossature (18) précédents, et il est simplement adossé audit jambage (30), avec, entre lui et ce jambage (30), des moyens de fixation débrayables.

2. Ossature suivant la revendication 1, caractérisée en ce que le jambage (30) de la pièce d'assemblage (16) se réduit à une collerette de configuration propre à permettre d'y adosser le troisième élément d'ossature (19).

3. Ossature suivant l'une quelconque des revendications 1, 2, caractérisée en ce que la partie médiane de jonction (29) de la pièce d'assemblage (16) présente, en saillie, à la racine, chacun respectivement, de ses bras (28), perpendiculairement au plan que ceux-ci forment avec son jambage (30), deux plots (45) propres à assurer une continuité de jonction entre les éléments d'ossature (18, 19) à assembler.

4. Ossature suivant la revendication 3, caractérisée en ce que, entre lesdits plots (45), la partie médiane de jonction (29) de la pièce d'assemblage (16) présente une échancrure (46).

5. Ossature suivant l'une quelconque des revendications 1 à 4, caractérisée en ce que, à son dos, la pièce d'assemblage (16) présente, en saillie, perpendiculairement au plan que forment ses bras (28) et son jambage (30), une console (48), propre à l'appui d'un quatrième élément d'ossature (20).

6. Ossature suivant la revendication 5, caractérisée en ce que, pour la fixation du quatrième élément d'ossature (20), ladite console (48) présente un perçage (51).

7. Ossature suivant l'une quelconque des revendications 1 à 6, caractérisée en ce que la partie médiane de jonction (29) de la pièce d'assemblage (16) présente une surface principale (37) plane, à compter de laquelle s'étend perpendiculairement son jambage (30), et deux surfaces latérales (38) planes, qui, parallèles l'une à l'autre, sont perpendiculaires à la surface principale (37) précédente, et à compter desquelles s'étendent chacun respectivement ses deux bras (28).

8. Ossature suivant l'une quelconque des revendications 1 à 7, caractérisée en ce que l'élément d'ossature (19) associé au jambage (30) de la pièce d'assemblage (16) est amovible individuellement, indépendamment de cette pièce d'assemblage (16) et des autres éléments d'ossature (18) qu'elle relie.

9. Ossature suivant l'une quelconque des revendications 1 à 8, caractérisée en ce que, par sa face tournée vers l'extérieur, l'élément d'ossature (19) associé au jambage (30) de la pièce d'assemblage (16) correspond fonctionnellement à deux éléments d'ossature (18) de même nature.

10. Ossature suivant l'une quelconque des revendications 1 à 9, caractérisée en ce que, parallèlement à l'élément d'ossature (19) associé au jambage (30) de la pièce d'assemblage (16), s'étend un autre élément d'ossature (56) qui, par sa face tournée vers l'intérieur, correspond fonctionnellement à deux éléments d'ossature (18) de même nature.

11. Ossature suivant la revendication 10, caractérisée en ce que, à son extrémité, ledit autre élément d'ossature (56) présente, latéralement, en saillie, deux pattes (61) par lesquelles il est apte à être assujetti aux éléments d'ossature (18) associés aux bras (28) de la pièce d'assemblage (16).

12. Ossature suivant l'une quelconque des revendications 5, 6, caractérisée en ce que le quatrième élément d'ossature (20) s'étend perpendiculairement au plan que forment avec le jambage (30) les bras (28) de la pièce d'assemblage (16).

13. Ossature suivant la revendication 12, caractérisée en ce que, à son extrémité, le quatrième élément d'ossature (20) présente, latéralement, en saillie, deux pattes (61) par lesquelles il est apte à être assujetti aux éléments d'ossature (18) associés aux bras (28) de la pièce d'assemblage (16).

14. Ossature suivant la revendication 12, caractérisée en ce que, la pièce d'assemblage (16) étant conforme à la revendication 6, le quatrième élément d'ossature (20) présente à son extrémité un trou (65) propre à en permettre l'assujettissement à la console (48) de cette pièce d'assemblage (16).

15. Ossature suivant l'une quelconque des revendications 1 à 14, caractérisée en ce que les éléments d'ossature (18) associés aux deux bras (28) de la pièce d'assemblage (16) sont reliés l'un à l'autre par une barrette (66).

16. Armoire, notamment pour appareillages électriques, du genre comportant côte à côte une pluralité de module (10A, 10B, 10C, 10D ...), caractérisée en ce que lesdits modules (10A, 10B, 10C, 10D ...) sont établis conjointement sur la base d'une même ossature (13) qui, elle-même de configuration modulaire, est conforme à l'une quelconque des revendications 1 à 15.

## Patentansprüche

1. Schrankskelett, insbesondere für elektrische Geräte, bestehend aus einer Vielzahl von Skelettelementen (18, 19, 20), die durch Verbindungsstücke (15, 16) miteinander verbunden sind, dadurch gekennzeichnet, daß mindestens eines der Verbindungsstücke (16) in einer allgemein T-förmigen Konfiguration einerseits zwei in einer Linie liegende Arme (28), die jeweils durch einfaches axiales Einstecken zwei Skelettelemente (18), wie Querträger oder Ständer, mit gleichem Querschnitt aufnehmen können, und andererseits senkrecht zu diesen Armen (28) auf Höhe eines mittleren Verbindungsteils (29), der sie miteinander verbindet, einen Fuß (30) aufweist, mit dem ein drittes Skelettelement (19), wie ein Ständer oder ein Querträger, zusammenarbeitet, das einen anderen Querschnitt als die vorhergehenden Skelettelemente (28) hat und an den Fuß (30) einfach angesetzt ist, wobei zwischen ihm und dem Fuß (30) auskuppelbare Befestigungseinrichtungen vorgesehen sind.

2. Skelett nach Anspruch 1, dadurch gekennzeichnet, daß der Fuß (30) des Verbindungsstücks (16) sich auf einen Kragen mit einer Konfiguration reduziert, die es gestattet, an diesen das dritte Skelettelement (19) anzusetzen.

3. Skelett nach einem der Ansprüche 1, 2, dadurch gekennzeichnet, daß der mittlere Verbindungsteil (29) des Verbindungsstücks (16) an der Wurzel jeweils jedes seiner Arme (28) senkrecht zu der Ebene, die diese mit seinem Fuß (30) bilden, hervorstehend zwei Erhebungen (45) besitzt, die eine Verbindungskontinuität zwischen den miteinander zu verbindenden Skelettelementen (18, 19) gewährleisten.

4. Skelett nach Anspruch 3, dadurch gekennzeichnet, daß der mittlere Verbindungsteil (29) des Verbindungsstücks (16) zwischen diesen Erhebungen (45) einen bogenförmigen Ausschnitt (46) besitzt.

5. Skelett nach einem der Ansprüche 1 bis 4, dadurch gekennzeichnet, daß das Verbindungsstück (16) an seinem Rükken senkrecht zu der Ebene, die seine Arme (28) und sein Fuß (30) bilden, hervorstehend eine Konsole (48) besitzt, die die Auflage eines vierten Skelettelements (20) gestattet.

6. Skelett nach Anspruch 5, dadurch gekennzeichnet, daß die Konsole (48) für die Befestigung des vierten Skelettelements (20) eine Bohrung (51) besitzt.

7. Skelett nach einem der Ansprüche 1 bis 6, dadurch gekennzeichnet, daß der mittlere Verbindungsteil (29) des Verbindungsstücks (16) eine ebene Hauptfläche (37), von welcher aus sich senkrecht sein Fuß (30) erstreckt, und zwei seitliche ebene Flächen (38) besitzt, die zueinander parallel und zur vorhergehenden Hauptfläche (37) senkrecht sind und von denen aus sich jeweils seine beiden Arme (28) erstrecken.

8. Skelett nach einem der Ansprüche 1 bis 7, dadurch gekennzeichnet, daß das dem Fuß (30) des Verbindungsstücks (16) zugeordnete Skelettelement (19) unabhängig von diesem Verbindungsstück (16) und den anderen Skelettelementen (18), die dieses verbindet, einzeln abnehmbar ist.

9. Skelett nach einem der Ansprüche 1 bis 8, dadurch gekennzeichnet, daß das dem Fuß (30) des Verbindungsstücks (16) zugeordnete Skelettelement (19) mit seiner nach außen gewandten Seite funktionell zwei Skelettelementen (18) derselben Art entspricht.

10. Skelett nach einem der Ansprüche 1 bis 9, dadurch gekennzeichnet, daß sich parallel zu dem dem Fuß (30) des Verbindungsstücks (16) zugeordneten Skelettelement (19) ein anderes Skelettelement (56) erstreckt, das mit seiner nach innen gewandten Seite funktionell zwei Skelettelementen (18) derselben Art entspricht.

11. Skelett nach Anspruch 10, dadurch gekennzeichnet, daß das andere Skelettelement (56) an seinem Ende seitlich vorstehend zwei Lappen (61) besitzt, mit denen es an den den Armen (28) des Verbindungsstücks (16) zugeordneten Skelettelementen (18) befestigt werden kann.

12. Skelett nach einem der Ansprüche 5, 6, dadurch gekennzeichnet, daß das vierte Skelettelement (20) sich senkrecht zu der Ebene erstreckt, die die Arme (28) des Verbindungsstücks (16) mit seinem Fuß (30) bilden.

13. Skelett nach Anspruch 12, dadurch gekennzeichnet, daß das vierte Skelettelement (20) seitlich vorstehend zwei Lappen (61) besitzt, mit denen es an den den Armen (28) des Verbindungsstücks (16) zugeordneten Skelettelementen (18) befestigt werden kann.

14. Skelett nach Anspruch 13, dadurch gekennzeichnet, daß, wenn das Verbindungsstück (16) gemäß Anspruch 6 ausgebildet ist, das vierte Skelettelement (20) an seinem Ende ein Loch (65) besitzt, das seine Befestigung an der Konsole (48) des Verbindungsstücks (16) gestattet.

15. Skelett nach einem der Ansprüche 1 bis 14, dadurch gekennzeichnet, daß die den beiden Armen (28) des Verbindungsstücks (16) zugeordneten Skelettelemente (18) miteinander durch einen Steg (66) verbunden sind.

16. Schrank, insbesondere für elektrische Einrichtungen, der nebeneinander eine Vielzahl von Modulen (10A, 10B, 10C, 10D ...) besitzt, dadurch gekennzeichnet, daß die Module (10A, 10B, 10C, 10D ...) zusammen auf der Basis eines gemeinsamen Skeletts (13) gebildet sind, das selbst eine Modulkonfiguration hat und gemäß einem der Ansprüche 1 bis 15 ausgebildet ist.

## Claims

1. A framework for a cabinet, in particular for electrical equipment, formed by a plurality of framework elements (18, 19, 20) connected by assembly members (15, 16), characterised in that one at least of the assembly members (16) having, in a general configuration of a T, on the one hand, in alignment with each other, two arms (28) which each respectively receive by simple axial engagement two framework elements (18) of the same cross-section such as cross members or upright members, and, on the other hand, perpendicularly to said arms (28), in line with a central junction portion (29) which connects them to each other, a leg means (30) with which there co-operates a third framework element (19) such as an upright member or a cross member, said third framework element (19) is of a cross-section that is different from that of the preceding framework elements (18) and it is simply placed against said leg means (30) with, between itself and the leg means (30), releasable fixing means.

2. A framework according to claim 1 characterised in that the leg means (30) of the assembly member (16) is reduced to a flange portion of a configuration such as to permit the third framework element (19) to be placed against same.

3. A framework according to either one of claims 1 and 2 characterised in that the central junction portion (29) of the assembly member (16) has in projecting relationship at the root of each respective one of its arms (28) perpendicularly to the plane that they form with its leg means (30) two studs (45) for ensuring continuity in the junction between the framework elements (18, 19) to be assembled.

4. A framework according to claim 3 characterised in that between said studs (45) the central junction portion (29) of the assembly member (16) has a cut-out (46).

5. A framework according to any one of claims 1 to 4 characterised in that, at its back, the assembly member (16) has in projecting relationship perpendicularly to the plane formed by its arms (28) and its leg means (30), a bracket (48) for supporting a fourth framework element (20).

6. A framework according to claim 5 characterised in that, for fixing the fourth framework element (20), said bracket (48) has an opening (51).

7. A framework according to any one of claims 1 to 6 characterised in that the central junction portion (29) of the assembly member (16) has a flat main surface (37) from which its leg means (30) extends perpendicularly, and two flat lateral surfaces (38) which, parallel to each other, are perpendicular to the preceding main surface (37), and from which respective ones of its two arms (28) each extend.

8. A framework according to any one of claims 1 to 7 characterised in that the framework element (19) associated with the leg means (30) of the assembly member (16) is removable individually independently of said assembly member (16) and the other framework elements (18) that it connects.

9. A framework according to any one of claims 1 to 8 characterised in that, in regard to its outwardly directed face, the assembly element (19) associated with the leg means (30) of the assembly member (16) functionally corresponds to two framework elements (18) of the same nature.

10. A framework according to any one of claims 1 to 9 characterised in that, extending parallel to the framework element (19) associated with the leg means (30) of the assembly member (16), is another framework element (56) which, in regard to its inwardly directed face, functionally corresponds to two framework elements (18) of the same nature.

11. A framework according to claim 10 characterised in that, at its end, said other framework element (56) is laterally provided in projecting relationship with two lugs (61) by way of which it can be fastened to the framework elements (18) associated with the arms (28) of the assembly member (16).

12. A framework according to either one of claims 5 and 6 characterised in that the fourth framework element (20) extends perpendicularly to the plane which the arms (28) of the assembly member (16) form with the leg means (30).

13. A framework according to claim 12 characterised in that at its end the fourth framework element (20) is laterally provided in projecting relationship with two lugs (61) by way of which it can be fastened to the framework elements (18) associated with the arms (28) of the assembly member (16).

14. A framework according to claim 12 characterised in that, the assembly member (16) being in accordance with claim 6, the fourth framework element (20) has at its end a hole (65) for permitting fastening thereof to the bracket (48) of the assembly member (16).

15. A framework according to any one of claims 1 to 14 characterised in that the framework elements (18) associated with the two arms (28) of the assembly member (16) are connected to each other by a small bar (66).

16. A cabinet, in particular for electrical equipment, of the kind comprising a plurality of modules (10A, 10B, 10C, 10D...) side-by-side, characterised in that said modules (10A, 10B, 10C, 10D...) are produced jointly on the basis of the same framework (13) which, itself being of modular configuration, is in accordance with any one of claims 1 to 15.
